# EUROPÄISCHE PATENTSCHRIFT

(11) **EP 4 201 161 B1**
(45) Veröffentlichungstag und Bekanntmachung des Hinweises auf die Patenterteilung: **18.12.2024**
(21) Anmeldenummer: 21762488.1
(22) Anmeldetag: 18.08.2021
(51) Int. Cl.: H05K 7/20, H05K 5/00, H05K 9/00, H02M 7/00

(54) **INVERTERSYSTEM FÜR EINEN ANTRIEBSSTRANG EINES KRAFTFAHRZEUGS**
INVERTER SYSTEM FOR A DRIVE TRAIN OF A MOTOR VEHICLE
MODULE CONVERTISSEUR D'UNE CHAÎNE CINÉMATIQUE D'UN VÉHICULE À MOTEUR

(30) Priorität: 21.08.2020 DE 102020121917
(43) Veröffentlichungstag der Anmeldung: 28.06.2023
(73) Patentinhaber: Voith Patent GmbH, 89522 Heidenheim (DE)
(72) Erfinder: HELWICH, Gerald, 3032 Eichgraben (AT); GRUBER, Christoph, 3385 Markersdorf (AT)
(74) Vertreter: Voith Patent GmbH - Patentabteilung
(86) Internationale Anmeldenummer: PCT/EP2021/072874
(87) Internationale Veröffentlichungsnummer: WO 2022/038162

(56) Entgegenhaltungen:
- US-A1- 2003 067 748

## Beschreibung

Die Erfindung betrifft Verbesserungen für ein Invertersystem für einen Antriebsstrang eines Kraftfahrzeugs.

Ein Invertersystem oder Umrichtereinrichtung ist zwischen einer Batterie und einem E-Motor angeordnet, so dass durch das Invertersystem die in der Batterie gespeicherte Energie dem Motor zugeführt werden kann. Das Invertersystem kann einzelne Untereinheiten, wie Stromwandler, Leistungshalbleiter, Zwischenkreiskondensatoren, Ansteuereinheiten (GDU) und eine Steuerplatine, umfassen, die vorzugsweise in einem Gehäuse untergebracht sind.

Um die Funktionssicherheit eines Invertersystems gewährleisten zu können, sind unterschiedliche Umgebungsbedingungen für die einzelnen Untereinheiten erforderlich. Insbesondere die große Abwärme der Leistungshalbleiter erfordert eine Kühlstruktur. Aus dem StdT sind entsprechende Kühltechniken oder Kühlstrukturen für Invertersysteme oder Umrichtereinheiten bekannt.

Die Leistungsumrichtereinheit, die in der JP 2015-130735 beschrieben ist, umfasst eine Gehäuseeinheit, die in einen ersten Gehäuseabschnitt und einen zweiten Gehäuseabschnitt aufgeteilt ist. Der erste Gehäuseabschnitt nimmt einen ersten Leistungsumrichter und eine erste Kühleinrichtung auf, die in eine Einheit integriert sind. Der zweite Gehäuseabschnitt dient als zweite Kühleinrichtung und ein zweiter Leistungsumrichter ist im Inneren des zweiten Gehäuseabschnitts angeordnet.

Aus der DE 10 2017 127 383 A1 ist ein weiterer Aufbau für eine Leistungsumrichtereinheit bekannt. Im Gehäuse der Leistungsumrichtereinheit sind zwei Kühleinheiten angeordnet die über einen Kühlmediumkanal verbunden sind. Die Untereinheiten sind entsprechend ihrer Wärmeentwicklung an einer der Kühlflächen der Kühleinheiten angeordnet.

Neben der Kühlung besteht bei einem Invertersystem das Problem, dass es aus EMV-Sicht zu einer Beeinflussung zwischen den Untereinheiten kommen kann, wenn diese in einem Gehäuse angeordnet sind oder die Abschirmung nicht ausreichend ausgeführt ist. Aus dem StdT ist bekannt die Abschirmung mittels Abschirmblechen oder sonstigen Zusatzmaßnahmen wie geschirmte Kabel, Schirmauflagen und Masseverbindungen, etc. zu realisieren.

Aus der US 2003 / 067 748 A1 ist ein Invertersystem für ein Kraftfahrzeug bekannt welches in einem Mehrteiligen Gehäuse angeordnet ist, wobei mehrere übereinander angeordnete Elektronikebenen vorgesehen sind und der Innenraum des Gehäuses mehrere Zonen aufweist.

Eine Aufgabe der vorliegenden Erfindung besteht darin, ein Invertersystem in einem Gehäuse vorzuschlagen, mit dem eine verbesserte Funktionalität und Betriebssicherheit des Invertersystems erreicht werden kann.

Die Aufgabe wird erfindungsgemäß durch eine Ausführung entsprechend dem unabhängigen Anspruch 1 gelöst. Weitere vorteilhafte Ausführungsformen der vorliegenden Erfindung finden sich in den Unteransprüchen.

Es wird ein Invertersystem für einen Antriebsstrang eines Kraftfahrzeugs vorgeschlagen, welches in einem mehrteiligen Gehäuse angeordnet ist, umfassend eine Steuerplatine die über Steuerkabelanschüsse mit Steuerleitungen verbindbar ist, Zwischenkreiskondensatoren, Leistungshalbleiter, Ansteuereinheiten (GDU), Stromwandlern und einem Anschlussbereich für DC-Eingang und Wechselrichterausgang.

Erfindungsgemäß wird vorgeschlagen, dass das Gehäuse übereinander angeordnete eine Elektronikebene, eine Leistungsebene und eine Anschlussebene umfasst, wobei der Innenraum des Gehäuses mehrere Zonen aufweist, in denen unterschiedliche Bedingungen in Bezug die Temperatur und/oder auf die EMV-Abschirmung herrschen. Gemäß der Erfindung ist unter einer Zone ein Bereich oder ein Raumbereich zu verstehen in dem gezielt bestimmte Umgebungsbedingungen hergestellt werden. So werden beispielsweise gezielt für eine Untereinheit bestimmte Temperaturbedingungen geschaffen oder es wird dafür gesorgt, dass aus EVM-Sicht eine gewünschte Abschirmung erfolgt.

Dabei wird das Gehäuse weiterhin erfindungsgemäß durch eine Trennwand in einen ersten Raum und einen zweiten Raum getrennt sein, wobei die Leistungsebene und die Steuerebene im ersten Raum angeordnet sind, der wiederum in mehrere Zonen unterteilt ist und die Anschlussebene im zweiten Raum angeordnet ist und eine Zone bildet.

Die Trennung der Räume ist derart ausgeführt, dass insbesondere kein gezielter Luftaustausch stattfinden kann.

Erfindungsgemäß ist im ersten Raum die Leistungsebene und die darunter angeordnete Steuerebene durch einen Kühlkörper getrennt. Im Gegensatz zur Trennwand ist der Kühlkörper aber nicht derart gestaltet, dass eine vollständig räumliche Trennung der Ebenen erfolgt.

Erfindungsgemäß weist die Leistungsebene und die Steuerebene jeweils zwei Zonen auf, wobei je Ebene eine Zone an eine erste Kühlzone des Kühlkörpers angrenzen und je Ebene eine Zone an eine zweite Kühlzone des Kühlkörpers angrenzen. Die Kühlkörperzonen haben jeweils eine Ober- und Unterseite an die jeweils eine Zone angrenzt.

So sind in einer bevorzugten Ausführung in der Leistungsebene die Leistungshalbleiter im Bereich der ersten Kühlzone und die Zwischenkreiskondensatoren im Bereich der zweiten Kühlzone auf dem Kühlkörper befestigt sind. Dabei bedeutet im Sinne der Erfindung befestigt gleichzeitig wärmeleitend verbunden.

Weiterhin erfindungsgemäß ist die Steuerplatine im Bereich der zweiten Kühlzone in einer Mulde des Kühlköppers angeordnet. Durch die Muldenform, wie auch den Werkstoff des Kühlkörpers, Aluminium, und die gewählte Wandstärke wird eine besonders gute EMV-Abschirmung erreicht, so dass auf weiter Abschirmelemente verzichtet werden kann.

Die Kopplung der Stromwandler und der Ansteuereinheiten (GDU) mit Steuerplatine erfolgt mittels Verbindungskabel, wobei die Verbindungskabel durch eine Zone verlaufen, die im Wesentlichen unterhalb des Kühlkörpers angeordnet ist. Weiterhin verlaufen die Verbindungskabel möglichst lang am Kühlkörper vorbei durch die Leistungsebene zur Anschlussebene, so dass sie auf dem wesentlichen Längenabschnitt vor dem Eintrag von Störungen (EMV) abgeschirmt sind.

Die Koppelung der Leistungshalbleiter mit den Zwischenkreiskondensatoren erfolgt mittels Stromschienen, wobei die Stromschienenverbindung Mittel umfasst, die eine thermische Entkoppelung von Leistungshalbleitern und Zwischenkreiskondensatoren ermöglicht bzw. den Eintrag von Wärme von den Leistungshalbleitern in die Zwischenkreiskondensatoren reduziert.

Diese Mittel können ein elektrisch isolierendes thermisch leitendes Element sein, mit dem Wärmeenergie von den Stromschienen auf das Gehäuseoberteil ableitbar ist.

Die beiliegenden Figuren zeigen ein mögliches Ausführungsbeispiel im Detail. Gezeigt werden im Einzelnen:
- Fig. 1: Invertersystem im Schnitt
- Fig. 2: Zonenaufteilung
- Fig. 3: Skizze Kühlkörper mit Steuerplatine
- Fig. 4: Invertersystem im Antriebsstrang

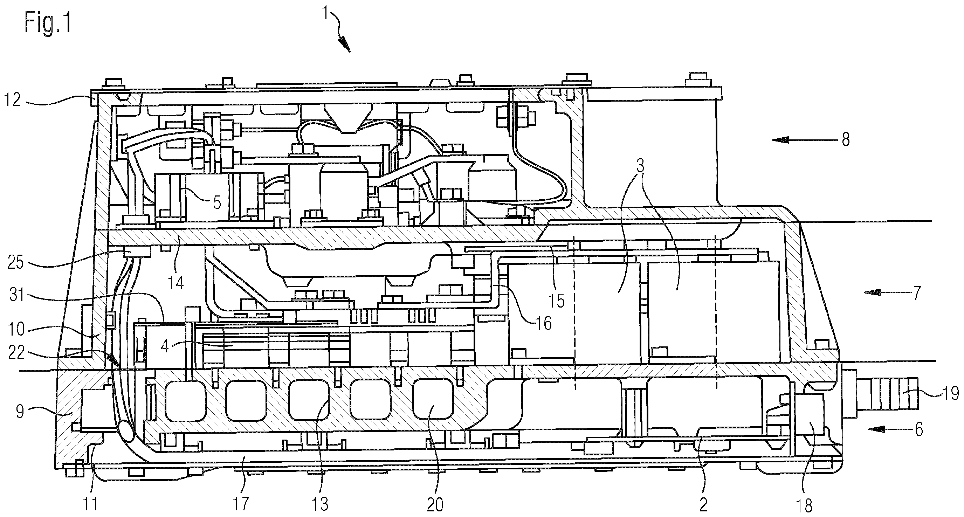

Figur 1 zeigt ein Invertersystem 1 im Schnitt, so dass alle wesentlichen Untereinheiten, wie die Stromwandler 5, die Ansteuereinheiten (GDU) 31, die Leistungshalbleiter 4, die Zwischenkreiskondensatoren 3 und die Steuerplatine 2 zu erkennen sind.

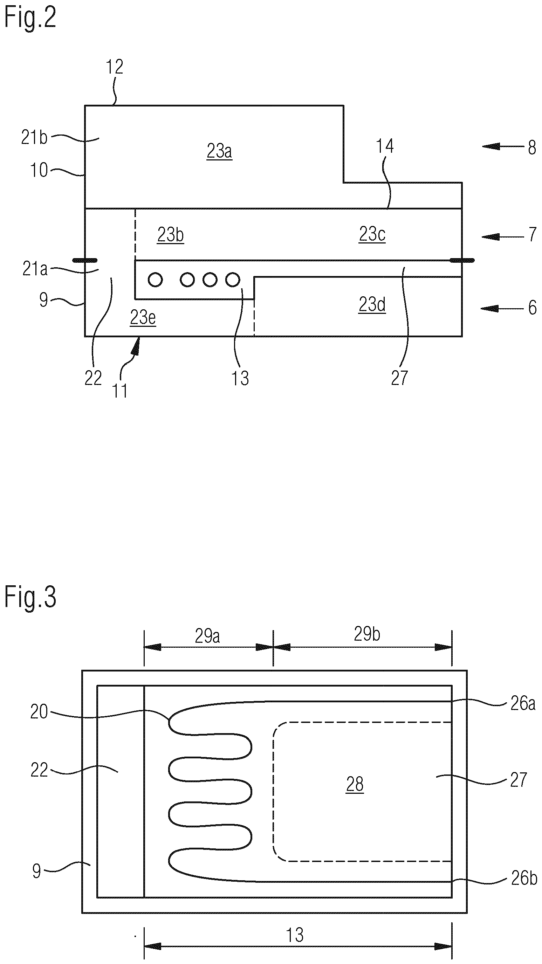

Figur 2 zeigt in einer Skizze den wesentlichen Aufbau des Gehäuses mit den einzelnen Zonen 23 a bis e in dem das Invertersystem 1 untergebracht ist.

Das aus dem Gehäuseunterteil 9, dem Gehäuseoberteil 10, dem Gehäuseboden 11 sowie dem Gehäusedeckel 12 zusammengesetzte Gehäuse weist drei Ebenen 6, 7 und 8 und fünf wesentliche Zonen 23 a-e innerhalb des Gehäuses auf, wobei das Gehäuse gegenüber der Umgebung abgedichtet ist. Die Ebenen 6 und 7, also die Elektronikebene 6 und die Leistungsebene 7, bilden dabei einen ersten Raum 21 a. Zwischen den Ebenen 6 und 7 ist der Kühlkörper 13 angeordnet und ein Durchgangsbereich 22, für die Steuerstromkabel 17, vorgesehen.

Die dritte Ebene 8, die Anschlussebene 8, ist ein separater Raum 21 b, die Zone 23 a, innerhalb des Gehäuses. Der Raum 21 b, der die Zone 23 a bildet, ist gegenüber dem Raum 21a durch die Trennwand 24 im Gehäuseoberteil 10 abgetrennt. Die notwendigen Steuerstromkabel 17 vom Stromwandler 5 zur Steuerplatine 2 und die Stromschienen zwischen Stromwandler 5 und Leistungshalbleitern 4 werden durch die Trennwand 24 geführt, wobei an den Durchführöffnungen Dichtungselemente vorgesehen sind, so dass die Räume 21 a und b getrennt sind.

Die einzelnen Zonen 23 a bis e haben unterschiedliche Funktionen die wesentlich für die Funktionalität des Invertersystems 1 sind. Der Anschlußbereich 8, Zone 23 a, ist ein abgeschlossener Bereich, der durch das Abnehmen des Gehäusedeckels sehr einfach zugänglich ist, so dass das An- und Abklemmen der fahrzeugseitigen Leistungsverdrahtung zur Montage oder Reparatur sehr einfach durchgeführt werden kann. Weiterhin kann die Verifikation der Spannungsfreiheit im Zwischenkreis bei geöffnetem Gehäusedeckel 12 vorgenommen werden.

Durch die Trennwand 14 wird nicht nur eine räumliche Trennung, sondern weiterhin eine thermische und EMV-Konforme Trennung zum Leistungsbereich 7 erreicht, so dass Stromwandler 5 und das dazugehörende DC-Schütz thermisch vom der Leistungsebene 7 entkoppelt und eine EMV-Schirmung gewährleistet sind.

Der Raum 21 a ist unterhalb der Anschlussebene angeordnet. Wie aus den Figuren 1 und 2 zu erkennen, umfasst dieser Raum den Leistungsbereich 7 und den Elektronikbereich 6, wobei der Raum 21 a in die vier Zonen 23 b bis e unterteilt ist. In der Zone 23 b sind die Leistungshalbleiter 4 auf dem Kühlkörper 13 positioniert, so dass die Abwärme der Leistungshalbleiter 4 effizient abgeführt werden kann. Auf der Leistungsebene 7 sind neben den Leistungshalbleitern 4 die Zwischenkreiskondensatoren 3, in Zone 23 c, auf dem Kühlkörper 13 befestigt, der in diesem Zonenbereich im Wesentlichen durch den Zu- und Abführkanal 26 a, b und einem verbindenden Steg 27 gebildet wird.

Die Leistungshalbleiter 4 und die Zwischenkreiskondensatoren 3 sind leistungsmäßig über kurze Stromschienen 16 verbunden, wobei diese in zwei unterschiedlichen thermischen Zonen 23 b und 23 c untergebracht sind. Unter einer thermischen Zone ist ein Bereich zu verstehen, in dem definierte Temperaturbedingungen herrschen, die gegenüber anderen Zonen bzw. Bereichen abweichen.

Als Trägerebene oder Befestigungsebene für die Leistungshalbleiter 4 und die Zwischenkreiskondensatoren 3 dient der Kühlkörper 13. Zur Realisierung der unterschiedlichen thermischen Bedingungen ist die Kühlkanalführung so gewählt, dass die Kühlkanäle nur im Bereich der Leistungshalbleiter verlaufen und die Zwischenkreiskondensatoren 3 auf dem Steg 27 zwischen dem Zu- und Abführkanal 26 a, b befestigt sind. Der Kühlkörper 13 weißt somit zwei Kühlzonen 29 a, b auf.

Zur weiteren thermischen Trennung von Leistungshalbleitern 4 und Zwischenkreiskondensatoren 3 ist eine thermische Unterbrechung vorgesehen, die verhindert zu großen Wärmeeintrag über die Stromschienen 16 von den Leistungshalbleitern 4 auf die Zwischenkreiskondensatoren 3. Dafür sind wärmeleitende aber elektrisch isolierende Verbindungen, sogenannte Thermoelemente oder Thermopads 15 zwischen Stromschienen 16 und Gehäuseoberteil 10 vorgesehen, die zumindest einen Teil der über die Stromschienen 16 weitergeleiteten Wärmeenergie auf das Gehäuse als Kühlkörper übertragen bzw. abführen.

In der weiteren Zone 23 d ist die Steuerplatine 2 angeordnet. Für die Steuerplatine 2 ist es wichtig, dass der Raum bzw. die Zone 23 d gegenüber hohen Temperaturen und gegenüber elektromagnetischen Wellen, EMV, abgeschirmt ist. Die Zone 23 d befindet sich unterhalb der Zwischenkreiskondensatoren 3. Der Steg 27 des Kühlkörpers 13 wird in diesem Bereich U-förmig vom Kühlkanal im Kühlkörper 13 umschlossen. Da der Steg 27 relativ dünn gegenüber dem Kühlkanalbereich ausgeführt ist, ergibt sich eine Mulde 28 unter der die Steuerplatine 2 positioniert ist. Die Muldenform, die damit einhergehende umhüllende Kubatur des Kühlkörpers und die Befestigung der Steuerplatine 2 in der Mulde 28 können so wirksam für die EMV-Abschirmung eingesetzt werden, insbesondere weil das Gehäuse 9 mit dem Kühlkörper 13 aus einer Aluminiumlegierung besteht.

Eine weitere Zone 23 e ist ein Bereich innerhalb des Gehäuses, durch den die Steuerstromkabel 17 geführt werden. Die Steuerstromkabel 17 verbinden die Stromwandler 5 und die Ansteuereinheiten (GDU) 31, mit der Steuerplatine 2 und sind entlang der Gehäusewand der Leistungsebene 7 und unterhalb des Kühlkörpers 13 in der Elektronikebene verlegt. Unterhalb des Kühlkörpers 13 sind die Steuerstromkabel 17 vom Leistungshalbleiterbereich, der Zone 23 b, abgeschottet, so müssen keine zusätzlichen Schirmanbindungen realisiert werden bzw. müssen die Steuerstromkabel 17 der Ansteuereinheiten (GDU) 31 nicht zusätzlich geschirmt ausgeführt werden.

Figur 3 zeigt eine Skizze des Gehäuseunterteils 9 mit dem Kühlkörper 13 und der an diesem befestigten Steuerplatine 2. Zu erkennen ist die Mulde 28 zwischen dem Zuund Abführkanal 26 a, b und dem dazwischen liegenden Steg 27, an dem die Steuerplatine 2 befestigt ist.

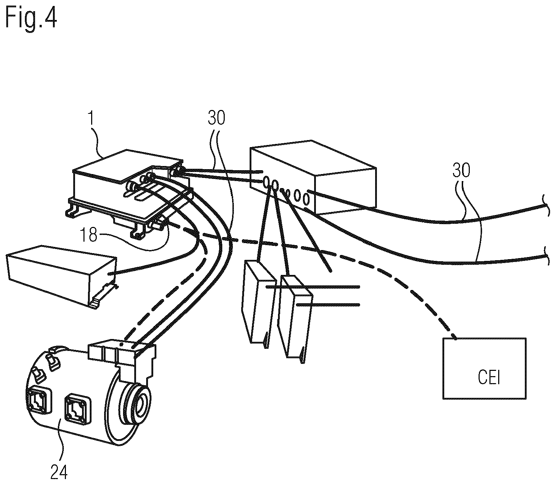

Weiter ist in Figur 4 das Invertersystem 1 im Antriebsstrang dargestellt. Diese Darstellung dient dem allgemeinen Verständnis und zeigt deutlich die Trennung der Anschlussebenen wie der Leistungsebene 8 an die Hochvoltkabel 30 angeschlossen sind und der Elektronikebene 6 mit den Steuerkabelanschlüssen 18 an Datenbuskabel angeschlossen sind.

### Bezugszeichenliste

- 1: Invertersystem
- 2: Steuerplatine
- 3: Zwischenkreiskondensator
- 4: Leistungshalbleiter
- 5: Stromwandler
- 6: Elektronikebene
- 7: Leistungsebene
- 8: Anschlussebene
- 9: Gehäuseunterteil
- 10: Gehäuseoberteil
- 11: Gehäuseboden
- 12: Gehäusedeckel
- 13: Kühlkörper
- 14: Trennwand
- 15: Thermoelement
- 16: Stromschienen
- 17: Steuerstromkabel
- 18: Steuerkabelanschluss
- 19: Kühlmittelanschluss
- 20: Kühlkanal
- 21 a- b: Raum
- 22: Durchgangsbereich
- 23 a-e: Zonen
- 24: Motor
- 25: Dichtelement
- 26 a, b: Zu- und Abführkanal
- 27: Steg
- 28: Mulde
- 29 a, b: Kühlzonen
- 30: Hochvoltkabel
- 31: Ansteuereinheit (GDU)

## Patentansprüche

1. Invertersystem (1) für einen Antriebsstrang eines Kraftfahrzeugs, welches in einem mehrteiligen Gehäuse (9, 10, 11, 12) angeordnet ist, umfassend eine Steuerplatine (2) die über Steuerkabelanschlüsse (18) mit Steuerleitungen verbindbar ist, Zwischenkreiskondensatoren (3), Leistungshalbleiter (4), Ansteuereinheiten (31) und Stromwandler (5), wobei das Gehäuse übereinander angeordnet eine Elektronikebene (6), eine Leistungsebene (7) und eine Anschlussebene (8) umfasst, wobei der Innenraum des Gehäuses (9, 10, 11, 12) mehrere Zonen (23 a-e) aufweist, in denen unterschiedliche Bedingungen in Bezug auf die Temperatur und auf die EMV-Abschirmung herrschen;
**dadurch gekennzeichnet, dass**
das Gehäuse (9, 10, 11, 12) weiterhin durch eine Trennwand (14) in einen ersten Raum (21a) und einen zweiten Raum (21 b) getrennt ist, wobei die Leistungsebene (7) und die Steuerebene (6) im ersten Raum (21 a) angeordnet sind, der wiederum in mehrere Zonen (23 b-e) unterteilt ist und die Anschlussebene (8) im zweiten Raum (21 b) angeordnet ist und eine Zone (23 a) bildet;
im ersten Raum (21a) die Leistungsebene (7) und die darunter angeordnete Steuerebene (6) durch einen Kühlkörper (13) getrennt ist;
die Leistungsebene (7) und die Steuerebene (6) jeweils zwei Zonen (23 b, c und 23 d, e) umfassen, wobei die Zonen (23 b und 23e) an eine erste Kühlzone (29 a) des Kühlkörpers (13) angrenzen und die Zonen (23 b und 23d) an eine zweite Kühlzone (29b) des Kühlkörpers (13) angrenzen.
in der Leistungsebene (7) die Leistungshalbleiter (4) im Bereich der ersten Kühlzone (29a) und die Zwischenkreiskondensatoren (3) im Bereich der zweiten Kühlzone (29b) auf dem Kühlkörper (13) befestigt sind.
die Steuerplatine (2) im Bereich der zweiten Kühlzone (29b) in einer Mulde (28) des Kühlköppers (13) angeordnet ist.

2. Invertersystem (1) nach Anspruch 1,
**dadurch gekennzeichnet, dass**
Stromwandler (5) und Steuerplatine (2) mittels Verbindungkabel (17) gekoppelt sind, wobei die Verbindungskabel (17) durch eine Zone (23e) verlaufen, die im Wesentlichen unterhalb des Kühlkörpers (13) angeordnet ist.

3. Invertersystem (1) nach Anspruch 1,
**dadurch gekennzeichnet, dass**
die Leistungshalbleiter (4) und die Zwischenkreiskondensatoren (3) mittels Stromschienen (16) gekoppelt sind, wobei die Stromschienenverbindung Mittel (15) umfasst, die eine thermische Entkoppelung von Leistungshalbleitern (4) und Zwischenkreiskondensatoren (3) ermöglicht.

4. Invertersystem (1) nach Anspruch 3,
**dadurch gekennzeichnet, dass**
das Mittel (15) ein elektrisch isolierendes Thermoelement ist, mit dem Wärmeenergie von den Stromschienen (16) auf das Gehäuseoberteil (10) ableitbar ist.

## Claims

1. Inverter system (1) for a drive train of a motor vehicle, which is arranged in a multipart housing (9, 10, 11, 12), comprising a control board (2) which is connectable by means of control cable terminals (18) and control lines, intermediate circuit capacitors (3), power semiconductors (4), actuation units (31) and power converters (5), wherein the housing comprises an electronics level (6), a power level (7) and a connection level (8), arranged one above another, wherein the interior of the housing (9, 10, 11, 12) comprises a plurality of zones (23 a - e) in which different conditions prevail, with respect to temperature and EMC shielding;
**characterized in that**
the housing (9, 10, 11, 12) is moreover divided by means of a dividing wall (14) into a first volume (21 a) and a second volume (21 b), wherein the power level (7) and the control level (6) are arranged in the first volume (21 a) which, in turn, is subdivided into a plurality of zones (23 b - e), and the connection level (8) is arranged in the second volume (21 b), and forms a zone (23 a);
in the first volume (21 a), the power level (7), and the control level (6) which is arranged thereunder, are separated by a heat sink (13);
the power level (7) and the control level (6) respectively comprise two zones (23 b, c and 23 d, e), wherein the zones (23 b and 23 e) adjoin a first cooling zone (29 a) of the heat sink (13), and the zones (23 b and 23 d) adjoin a second cooling zone (29 b) of the heat sink (13);
in the power level (7), the power semiconductors (4) are fastened in the region of the first cooling zone (29 a), and the intermediate circuit capacitors (3) are fastened to the heat sink (13) in the region of the second cooling zone (29 b);
the control board (2) is arranged in the region of the second cooling zone (29 b), in a depression (28) of the heat sink (13).

2. Inverter system (1) according to Claim 1,
**characterized in that**
the power converters (5) and the control board (2) are coupled by means of connecting cables (17), wherein the connecting cables (17) are routed through a zone (23 e) which is essentially arranged below the heat sink (13).

3. Inverter system (1) according to Claim 1,
**characterized in that**
the power semiconductors (4) and the intermediate circuit capacitors (3) are coupled by means of conductor rails (16), wherein the conductor rail connection comprises means (15) which permit a thermal decoupling of the power semiconductors (4) and intermediate circuit capacitors (3) .

4. Inverter system (1) according to Claim 3,
**characterized in that**
the means (15) comprise an electrically insulating thermoelement, by means of which thermal energy can be diverted from the conductor rails (16) to the upper housing part (10).

## Revendications

1. Système convertisseur (1) qui est destiné à une chaîne cinématique d'un véhicule automobile et qui est disposé dans un boîtier (9, 10, 11, 12) formé de plusieurs parties, ledit système convertisseur comprenant une carte de commande (2) qui peut être reliée à des lignes de commande par le biais de bornes de câbles de commande (18), des condensateurs de circuit intermédiaire (3), des semi-conducteurs de puissance (4), des unités d'excitation (31) et des transformateurs de courant (5), le boîtier comprenant de manière superposée un niveau d'électronique (6), un niveau de puissance (7) et un niveau de bornes (8),
l'espace intérieur du boîtier (9, 10, 11, 12) comportant plusieurs zones (23 a-e) dans lesquelles règnent différentes conditions en rapport avec la température et le blindage CEM ;
**caractérisé en ce que**
le boîtier (9, 10, 11, 12) est en outre séparé par une cloison (14) en un premier espace (21a) et un deuxième espace (21b), le niveau de puissance (7) et le niveau de commande (6) étant disposés dans le premier espace (21a), lui-même divisé en plusieurs zones (23b-e), et le niveau de bornes (8) étant disposé dans le deuxième espace (21b) et formant une zone (23a) ;
dans le premier espace (21a) le niveau de puissance (7) et le niveau de commande (6) sous-jacent sont séparés par un dissipateur thermique (13) ;
le niveau de puissance (7) et le niveau de commande (6) comprennent chacun deux zones (23b,c et 23d,e), les zones (23b et 23e) étant adjacentes à une première zone de refroidissement (29a) du dissipateur thermique (13) et les zones (23b et 23d) étant adjacentes à une deuxième zone de refroidissement (29b) du dissipateur thermique (13),
au niveau de puissance (7) les semi-conducteurs de puissance (4) dans la région de la première zone de refroidissement (29a) et les condensateurs de circuit intermédiaire (3) dans la région de la deuxième zone de refroidissement (29b) sont fixés au dissipateur thermique (13),
la carte de commande (2) est disposée dans la région de la deuxième zone de refroidissement (29b) dans un creux (28) du dissipateur thermique (13).

2. Système convertisseur (1) selon la revendication 1,
**caractérisé en ce que**
le transformateur de courant (5) et la carte de commande (2) sont couplés à l'aide d'un câble de liaison (17), les câbles de liaison (17) traversant une zone (23e) qui est disposée sensiblement au-dessous du dissipateur thermique (13).

3. Système convertisseur (1) selon la revendication 1,
**caractérisé en ce que**
les semi-conducteurs de puissance (4) et les condensateurs de circuit intermédiaire (3) sont couplés au moyen de barres conductrices (16), la liaison par barres conductrices comprenant des moyens (15) qui permettent le découplage thermique de semi-conducteurs de puissance (4) et de condensateurs de circuit intermédiaire (3).

4. Système convertisseur (1) selon la revendication 3,
**caractérisé en ce que**
le moyen (15) est un thermocouple électriquement isolant avec lequel l'énergie thermique peut être dissipée des barres conductrices (16) vers la partie supérieure (10) du boîtier.
